Europäisches Patentamt

(19) European Patent Office

Office européen des brevets

(11) Numéro de publication: **0 187 580**

**A1**

## (12) DEMANDE DE BREVET EUROPEEN

(21) Numéro de dépôt: 85402435.3

(22) Date de dépôt: 06.12.85

(51) Int. Cl.⁴: **H 05 K 7/20**

(30) Priorité: 11.12.84 FR 8418927

(43) Date de publication de la demande:
16.07.86 Bulletin 86/29

(84) Etats contractants désignés:
DE FR GB NL

(71) Demandeur: THOMSON-CSF
173, Boulevard Haussmann
F-75379 Paris Cedex 08(FR)

(72) Inventeur: Barré, Lucien
THOMSON-CSF SCPi 19, Av. de Messine
F-75008 Paris(FR)

(74) Mandataire: Guérin, Michel et al,
THOMSON-CSF SCPI 19, avenue de Messine
F-75008 Paris(FR)

(54) Boîtier pour composant de puissance haute-fréquence refroidi par ciculation d'eau.

㊗ L'invention concerne un boîtier pour composants de puissance foctionnant en haute frequence. Le boîtier comporte un corps principal (20) thermiquement conducteur avec une cavité dans laquelle est logé le composant, et des canaux de circulation forcée de fluide. Le boîtier est inséré dans une fenêtre (14) découpée dans une plaque de circuit imprimé (12). Un rebord en saillie (24) s'appuie contre le bord de la fenêtre, tandis que des électrodes planes (28), sortant du boîtier dans le même plan que le rebord, s'appuient contre des connexions (18) imprimées sur la plaque (12). Au dessous de la plaque, on connecte les canaux de circulation forcée de fluide de refroidissement à des conduits d'amenée et d'evacuation.

On réalise ainsi un bon compromis entre les contraintes d'encombrement importantes pour des circuits fonctionnant en haute fréquence, et l'efficacité de la dissipation de chaleur.

FIG_1

EP 0 187 580 A1

## BOITIER POUR COMPOSANT DE PUISSANCE HAUTE-FREQUENCE REFROIDI PAR CIRCULATION D'EAU

L'invention concerne les boîtiers de composants de puissance devant fonctionner à haute fréquence.

Les boîtiers existants se prêtent mal à la dissipation de fortes puissances (de l'ordre de 1 kilowatt), notamment à cause de la difficulté de trouver des compromis entre l'obtention d'un bon refroidissement des composants et la réduction de l'encombrement du boîtier et de son système de refroidissement. On sait en effet que pour des circuits fonctionnant à haute fréquence les dimensions des connexions sont critiques car elles introduisent des capacités et inductances parasites, et il est nécessaire de les limiter au maximum. Le boîtier de dissipation de chaleur d'un composant mis en place sur un circuit imprimé a des dimensions qui réagissent sur la longueur et la position des connexions entre ce composant et les autres éléments du circuit imprimé. D'autre part la haute fréquence impose encore d'autres précautions qui ne sont pas toujours compatibles avec les exigences précédentes. Enfin, les raccords de connexions doivent être autant que possible ramenés dans un même plan, ces dispositifs étant systématiquement montés sur circuit imprimé.

La présente invention propose une structure nouvelle de boîtier permettant un très bon compromis tel que défini ci-dessus. Cette structure s'adapte à l'encapsulation d'un composant unique ou de plusieurs composants dans le même boîtier.

Le boîtier comprend un corps principal thermiquement conducteur, pourvu d'une cavité destinée à loger au moins un composant, ainsi que des évidements formés dans le corps principal et des ouvertures d'accès à ces évidements pour introduire et évacuer un fluide de refroidissement en circulation forcée ; sur une partie de sa périphérie, le corps principal est pourvu d'un rebord en saillie ayant une surface inférieure plane constituant une surface d'appui lorsque le corps du boîtier est inséré dans une fenêtre découpée dans une plaque de circuit imprimé ; sur une autre partie de la périphérie du corps principal, des électrodes planes sortent de la cavité, dans laquelle elles sont reliées au composant, ces électrodes ayant leur face inférieure située dans le plan de ladite surface d'appui de manière que lorsque le corps du boîtier est inséré dans ladite fenêtre les électrodes viennent en appui contre des connexions imprimées sur la plaque, connexions qui aboutissent sensiblement au bord de la fenêtre percée dans la plaque ; enfin, les ouvertures d'accès aux évidements sont placées au-dessous du plan de la surface d'appui et à une distance suffisante de ce plan pour qu'il soit possible, lorsque le corps du boîtier est placé dans le fenêtre de la plaque, de connecter à ces ouvertures des conduits d'amenée et d'évacuation de fluide qui se situent par conséquent au-dessous de la plaque de circuit imprimé, c'est-à-dire du côté opposé à celui qui supporte les électrodes planes en contact avec les connexions du circuit imprimé.

De préférence les ouvertures se situent dans une face du corps principal parallèle ou perpendiculaire à la surface d'appui plane et les conduits qui y sont connectés sortent perpendiculairement à cette face.

D'autre caractéristiques et avantages de l'invention apparaîtront à la lecture de la description détaillée qui suit et qui est faite en référence aux dessins annexés dans lesquels :

- la figure 1 représente une vue en perspective du boîtier placé au-dessus d'une fenêtre découpée dans une plaque de circuit imprimé ;

- la figure 2 représente, en vue latérale, le boîtier mis en place dans cette fenêtre et raccordé à des conduits de circulation de fluide de refroidissement ;

- les figures 3 à 5 représentent le corps principal du boîtier, respectivement en coupe transversale, en coupe longitudinale, et en vue de dessus ;

- la figure 6 représente les éléments mis en place dans la cavité du corps principal du boîtier.

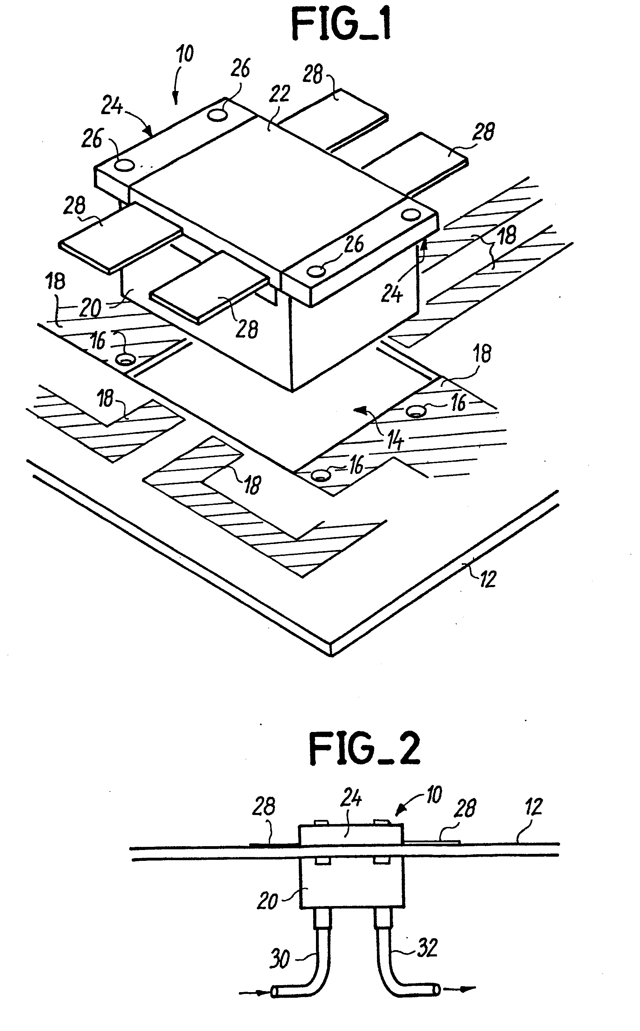

Sur la figure 1, on a représenté en perspective le boîtier 10 selon l'invention, placé au-dessus d'une plaque de circuit imprimé 12 sur laquelle ce boîtier doit être monté.

Dans l'exemple représenté, le boîtier a une forme générale parallélépipédique et il est destiné à être inséré dans une fenêtre rectangulaire 14 découpée dans la plaque de circuit imprimé 12. Il est aussi destiné à être fixé sur cette plaque en principe par des boulons ou rivets passant dans des ouvertures circulaires 16 percées à proximité de la fenêtre 14.

Des connexions imprimées 18 arrivent à proximité de la fenêtre 14 et c'est à ces connexions que doit être relié électriquement le composant de puissance (ou les composants de puissance) enfermé dans le boîtier 10. Sur la figure 1 on a représenté à titre d'exemple quatre connexions imprimées. Ces connexions permettent de relier le ou les composants à d'autres éléments du circuit imprimé.

Dans ce qui suit et dans les revendications, on appellera dessus ou surface supérieure de la plaque de circuit imprimé le côté (visible sur la figure 1) qui porte ces connexions, et dessous ou surface inférieure le côté opposé, non visible sur la figure 1. De même on appellera dessus ou surface supérieure d'autres éléments les côtés ou surfaces parallèles aux surfaces de la plaque et visibles dans la direction d'observation du boîtier sur la figure 1, par opposition au dessous ou surface inférieure de ces éléments, non visibles dans la direction d'observation en perspective de la figure 1.

Le boîtier 10 comprend un corps principal 20 en matière conductrice de la chaleur (cuivre par exemple) car, outre son rôle de protection du composant qu'il contient, il joue le rôle de dissipateur de la chaleur engendrée dans le composant. Le corps principal comporte une cavité dans laquelle est logé le composant ou les composants. Cette cavité n'est pas visible sur la vue extérieure de la figure 1, mais on aperçoit un couvercle 22 qui la ferme dans l'exemple représenté. Il s'agit par exemple d'un couvercle de résine de protection électriquement isolante, injectée dans la cavité pour noyer le composant.

La partie inférieure du corps principal 20 a des dimensions correspondant sensiblement à celles de la fenêtre 14 pour pouvoir être insérée dans cette fenêtre. Cette partie inférieure est ici rectangulaire. La partie supérieure comprend en outre, sur une partie de sa périphérie, un rebord en saillie 24 (ici un rebord sur un côté du rectangle et un autre rebord sur un côté opposé du rectangle). Le rebord 24 en saillie a une face inférieure plane définissant une surface d'appui, qui vient s'appuyer sur les bords de la fenêtre 14 découpée dans la plaque de circuit imprimé 12 lorsque le corps principal 20 est inséré dans cette fenêtre.

Le rebord 24 est percé d'ouvertures circulaires 26 de dimensions et positions adaptées à celles des ouvertures 16 de la plaque de circuit imprimé, pour permettre la fixation solide du boîtier contre la plaque. Lorsque l'insertion et la fixation du boîtier est faite, la majeure partie de la hauteur du corps principal 20 se situe au-dessous de la plaque de circuit imprimé 22.

De la cavité fermée contenant le composant sortent des électrodes métalliques planes, ici quatre électrodes 28. Ces électrodes sortent d'une partie du corps principal 20 non pourvue d'un rebord en saillie 24. Elles sont coplanaires et le plan de leur surface inférieure coïncide avec le plan de la surface d'appui constituée par la face inférieure du rebord en saillie 24. Les positions latérales des différentes électrodes 28 correspondent aux positions des connexions imprimées 18 de la plaque 12 ; lorsque le boîtier est fixé sur la plaque, les rebords en saillie s'appliquent étroitement contre les bords de la fenêtre 14 et les électrodes planes 28 s'appliquent étroitement chacune contre une connexion respective 18, assurant un raccord électrique efficace dans un même plan, de deux conducteurs plans.

Le corps principal 20 du boîtier comporte des évidements internes non visibles sur la figure 1, destinés à assurer la circulation d'un fluide de refroidissement mis en circulation forcée. Ces évidements débouchent à l'extérieur du corps 20 sur des ouvertures (en principe une ouverture d'amenée de fluide et une ouverture d'évacuation) qui peuvent être raccordées à des conduits de circulation de fluide.

Les ouvertures sont placées au-dessous du plan de la surface d'appui des rebords 24 et donc du plan de la face inférieure des électrodes 28, à une distance suffisante de ce plan pour que lorsque le boîtier est mis en place sur la plaque 12 les ouvertures et les conduits qui y sont raccordés se situent au-dessous de la plaque 12 (alors que les électrodes sont au dessus).

La figure 2 montre une vue latérale du boîtier 10 monté sur la plaque, avec les électrodes 28 qui reposent sur la plaque et des conduits de circulation forcée 30 (arrivée) et 32 (départ) raccordés respectivement à une ouverture d'amenée de fluide et une ouverture d'évacuation de fluide qui en l'occurence sont tournées vers le bas ; au lieu d'être percées dans la face inférieure du boîtier (face parallèle au plan des électrodes), ces ouvertures pourraient être formées dans les faces latérales, mais assez loin du plan de la surface inférieure de la plaque 12 pour que les conduits puissent être mis facilement en place au-dessous de la plaque.

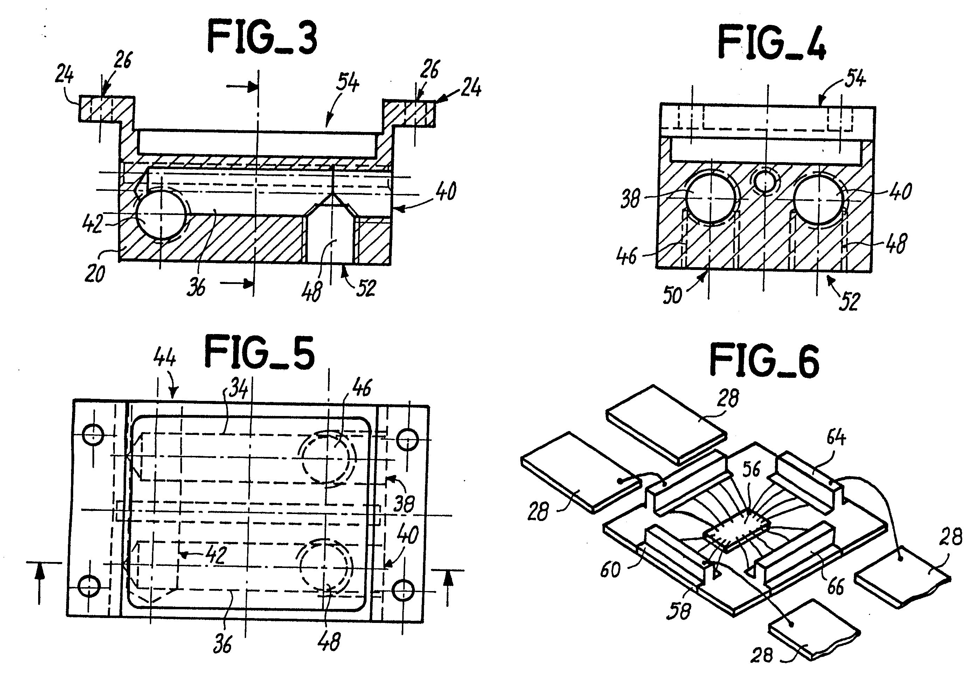

Les figures 3 à 5 représentent, respectivement en coupe transversale, en coupe longitudinale et en vue de dessus le corps principal du boîtier ; le composant, et la résine qui noie le composant et ferme la cavité dans laquelle est logé le composant, n'ont pas été représentés sur ces figures, ainsi que les électrodes de connexion extérieure.

On voit clairement sur ces figures que plusieurs canaux ou évidements sont formés dans le corps principal 20, avec des ouvertures d'accès à ces canaux débouchant à l'extérieur du corps principal. Les évidements sont ici réalisés par des perçages horizontaux (longitudinaux et transversaux) et des perçages verticaux. Ces perçages se coupent mutuellement et forment donc des chemins de communication aptes à permettre la circulation d'un fluide de refroidissement entre deux ouvertures extérieures.

Plus précisément, on voit ici deux canaux horizontaux parallèles 34 et 36 percés dans un sens qu'on appellera longitudinal, débouchant par deux ouvertures extérieures respectives 38 et 40. La coupe de la figure 3 est faite à travers le canal 36. Un canal horizontal 42 percé dans un sens transversal fait communiquer, à leur extrémité opposée aux ouvertures 38 et 40, les canaux longitudinaux 34 et 36. Ce canal 42 débouche sur une ouverture 44. Deux canaux verticaux 46 et 48 peuvent en outre être percés de la surface inférieure du corps principal vers les canaux longitudinaux 34 et 36 vers leurs extrémités du côté des ouvertures 38 et 40. Ces canaux 46 et 48 débouchent sur la face inférieure du corps 20 par des ouvertures 50 et 52 respectivement.

Les ouvertures 38 et 40 ainsi que les ouvertures (50 et 52) sont situées largement au-dessous du plan de la surface d'appui (face inférieure) des rebords en saillie 24. Les ouvertures des différents canaux sont filetées pour pouvoir y fixer soit un bouchon (notamment dans l'ouverture 44), soit un raccord de connexion pour un conduit d'amenée ou d'évacuation de fluide en circulation forcée.

Par exemple, on bouche les ouvertures 38 et 40 et on raccorde les ouvertures 50 et 52 à des conduits ; on peut aussi faire le contraire, à savoir boucher les ouvertures 50 et 52 et raccorder des conduits aux ouvertures 38 et 40.

Pour terminer la description des figure 3 à 5, on voit que la partie supérieure du corps principal 20, non percée de canaux, comporte une large cavité 54 ouverte vers le haut, pour la réception de plusieurs éléments qui sont :

- le ou les composants de puissance,

- les extrémités des électrodes 28 auxquelles sont reliés ces composants,

- une plaque isolante pour isoler les électrodes du corps du boîtier ou éventuellement un petit circuit imprimé (pistes conductrices imprimées sur support isolant) sur lequel sont placés les composants et contre lequel viennent s'appliquer les électrodes,

– enfin une résine isolante de protection qui remplira la cavité après mise en place des différents éléments qui précèdent.

Les éléments destinés à venir à l'intérieur de la cavité sont représentés sur la figure 6 dans le cas d'un composant unique à quatre connexions (quatre électrodes de face avant de la puce constituant le composant et une électrode de face arrière).

La puce est désignée par la référence 56. Elle est en général soudée par sa face arrière sur une piste conductrice imprimée d'une plaque isolante 58. La puce est raccordée électriquement à des plots 60, 62, 64, 66 qui eux mêmes sont reliés par des fils soudés à des électrodes conductrices 28 découpées dans une plaque de métal.

Lorsqu'on met en place la plaque 58 dans la cavité 54 puis les électrodes, la partie avant des électrodes déborde hors du boîtier sur les côtés qui ne sont pas entourés par le rebord en saillie 24. Pour faciliter la mise en place des électrodes, on peut prévoir qu'elles sont solidaires d'un cadre de maintien périphérique non représenté, qui sera découpé pour isoler les électrodes les unes des autres a la fin du montage (cadre de dimensions supérieures à celles du boîtier).

Les électrodes sont mises en place et les fils de liaison sont soudés après quoi une résine de protection est alors mise en place pour fermer la cavité 54.

Il est à noter que l'on peut prévoir d'autres plaques électriquement isolantes, de préférence thermiquement conductrices (alumine) entre le fond de la cavité 54 et la plaque de support imprimée 58.

L'épaisseur totale des éléments installés dans la cavité 54 doit être telle que la surface inférieure des électrodes affleure dans le plan de la surface inférieure du rebord en saillie 24.

# R E V E N D I C A T I O N

Boîtier pour composants électronique de puissance, comprenant un corps principal (20) thermiquement conducteur pourvu d'une cavité (54) destinée à loger au moins un composant (56), ainsi que des évidements (34, 36, 42, 46, 48) percés dans le corps principal et des ouvertures (50, 52) d'accès à ces évidements pour introduire et évacuer un fluide de refroidissement en circulation forcée, caractérisé en ce que :

- sur une partie de sa périphérie, le corps principal est pourvu d'un rebord en saillie (24) ayant une surface inférieure plane constituant une surface d'appui lorsque le corps du boîtier est inséré dans une fenêtre (14) découpée dans une plaque de circuit imprimé (12),

- sur une autre partie de la périphérie du corps principal, des électrodes planes (28) sortent de la cavité, dans laquelle elles sont reliées au composant, ces électrodes ayant leur face inférieure située dans le plan de ladite surface d'appui de manière que lorsque le corps du boîtier est inséré dans ladite fenêtre les électrodes viennent en appui contre des connexions imprimées (18) sur la plaque, connexions qui aboutissent sensiblement au bord de la fenêtre ;

- les ouvertures (50, 52) d'accès aux évidements sont placées au-dessous du plan de la surface d'appui et à une distance suffisante de ce plan pour qu'il soit possible, lorsque le corps du boîtier est placé dans la fenêtre de la plaque, de connecter à ces ouvertures des conduits d'amenée (30) et d'évacuation (32) de fluide qui se situent par conséquent de l'autre côté de la plaque support par rapport aux électrodes planes.

# FIG_1

# FIG_2

## FIG_3

54
40
26   26   24
24
42
20
36   48   52

## FIG_4

54
38   40
46   48
50   52

## FIG_5

44   34   46
42   38
40
36   48

## FIG_6

28
28   56   64
60   58   66   28
28

2/2

0187580

Office européen
des brevets

**RAPPORT DE RECHERCHE EUROPEENNE**

Numero de la demande

EP  85 40 2435

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 079 410  (SCHIERZ)<br>* Figure 1; colonne 3, ligne 47 - colonne 4, ligne 20 * | 1 | H 05 K   7/20 |
| A | US-A-4 504 886  (CYGAN)<br>* Colonne 2, lignes 28-55; figure 1 * | 1 | |
| A | US-A-4 341 432  (CUTCHAW)<br>* Figures 1-3; colonne 7, lignes 16-45 * | 1 | |
| A | FR-A-2 316 737  (HONEYWELL) | | |

DOMAINES TECHNIQUES
RECHERCHES (Int  Cl.4)

H 05 K
H 01 L

Le présent rapport de recherche a été établi pour toutes les revendications

| Lieu de la recherche | Date d'achèvement de la recherche | Examinateur |
|---|---|---|
| LA HAYE | 14-02-1986 | TOUSSAINT F.M.A. |